(19) **Europäisches Patentamt**
**European Patent Office**
**Office européen des brevets**

(11) **EP 1 939 146 A1**

(12) **EUROPÄISCHE PATENTANMELDUNG**

(43) Veröffentlichungstag:
**02.07.2008 Patentblatt 2008/27**

(51) Int Cl.:
*C03B 19/06* (2006.01)    *B28B 1/26* (2006.01)

(21) Anmeldenummer: **07122836.5**

(22) Anmeldetag: **11.12.2007**

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **21.12.2006 DE 102006060561**

(71) Anmelder: **Schott AG**
**55122 Mainz (DE)**

(72) Erfinder:
- **Borens, Manfred**
  **55126 Mainz (DE)**
- **Eckes, Franz-Peter**
  **55270 Bubenheim (DE)**

- **Zborowski, Janus**
  **55218 Ingelheim (DE)**
- **Von Westernhagen, Karsten**
  **55270 Essenheim (DE)**
- **Merolla, Stefano**
  **55129 Mainz (DE)**
- **Witte, Jörg**
  **64319 Pfungstadt (DE)**
- **Küster, Joachim**
  **64390 Erzhausen (DE)**
- **Holla, Marcus**
  **55234 Biebelnheim (DE)**

(74) Vertreter: **Fuchs**
**Patentanwälte**
**Söhnleinstraße 8**
**65201 Wiesbaden (DE)**

(54) **Quarzglasformkörper und Verfahren und Gussform zu dessen Herstellung**

(57) Die Erfindung betrifft einen verbesserten Quarzglasformkörper, insbesondere einen Quarzglastiegel für das Verflüssigen von Nichtmetallen, Nichteisenmetallen oder Silizium, ein Verfahren und eine Gussform zu dessen Herstellung. Ein Quarzglas-Wassergemisches wird in eine Gussform mit einer Außenform (102) und einer Innenform (100) eingebracht, darin getrocknet und der so erzeugte Grünkörper entformt. Zumindest Teile (101) der formgebenden Flächen der Innenform werden aus einer wasserdichten Substanz gebildet. Während des Trocknens wirkt ein Überdruck auf das Quarzglas-Wassergemisch. Auf diese können Formkörper mit einer sehr geringen Rissbildungsneigung und einer geringen offenen Porosität hergestellt werden.

Die Gussform weist einer Einfüllstutzen oberhalb eines oberen Tiegelrandes und eine Einlassöffnung im Tiegelbodenbereich auf.

Fig. 2

**Beschreibung**

Die Erfindung betrifft ein Verfahren und eine Gussform zur Herstellung von Quarzglasformkörpern sowie verbesserte Quarzglasformkörper, insbesondere Behälter oder Tiegel für das Verflüssigen von Nichtmetallen oder Nichteisenmetallen und hierbei insbesondere zur Herstellung von Siliziumblöcken, aus denen Photovoltaik-Module hergestellt werden.

Für die Herstellung von Silizium-Blöcken werden vorwiegend Behälter aus Sinterquarzglas verwendet. Solche Behälter bzw. Formkörper und deren Herstellungsverfahren sind beispielsweise aus der DE 102 51 076 oder der DE 102 44 040 bekannt. Die Behälter werden im Wesentlichen mit folgenden Verfahrensschritten hergestellt.

1. Herstellung eines Quarzglas-Wassergemisches, des so genannten Schlickers, mit bestimmter Korngröße des Quarzglases (anorganisch erstarrtes $SiO_2$) und mit bestimmtem Verhältnis aus Quarzglas und Wasser,

2. Einbringen des Quarzglas-Wassergemisches in eine Gussform, typischerweise eine Gipsform, welche eine Außenform und eine Innenform aufweist,

3. Trocknen des Quarzglas-Wassergemisches in der Gussform, wobei das Wasser in den Gips der Gussform diffundiert und so der Masse des Quarzglas-Wassergemisches entzogen wird,

4. Entformen des so erzeugten Grünkörpers, das heißt Entnahme des Grünkörpers aus der Gipsform.

Beim Entformen des Grünkörpers aus der Gipsform treten erfahrungsgemäß immer wieder Probleme auf, insbesondere wenn es sich um großformatige Behälter handelt. Solche Probleme sind beispielsweise in der DE 102 51 076 behandelt. Dort wird vorgeschlagen, anstelle eines fertig gegossenen Quarzglas-Behälters einen aus mehreren Platten zusammengesetzten Behälter zu verwenden.

Ein anderes Problem ergibt sich daraus, das es oftmals gewünscht ist, die mit dem Schmelzgut in Verbindung stehende Behälterwand mit einem feinkörnigen Gefügeaufbau zu versehen, worunter andererseits aber die Festigkeit eines solchen Behälters leidet. Dieses Problem ist in der DE 102 44 040 angesprochen und wird dort gelöst, indem der Behälter mehrschichtig aufgebaut ist, wobei eine dem Schmelzgut zugewandte Schicht feinkörniger und die daran angrenzende dem Schmelzgut abgewendete Schicht des Behälters grobkörniger ausgestaltet ist.

Ferner ist beispielsweise aus der WO 2006/089754 oder der EP 1 516 864 A2 bekannt, eine Gussform zur Herstellung des Formkörpers vorzusehen, die eine flüssigkeitsundurchlässige Formwandung aufweist, um einen Wasserverlust über diese Formwandung zu verhindern.

Schließlich wird der Grünkörper nach dem Entformen zu einem stabilen Behälter versintert.

Grundsätzlich kann beim Gießen sowohl das Hohlgussverfahren als auch das Gießen mit Kern eingesetzt werden. Beide Verfahren sind in der Herstellung von Quarzglasbehältern der eingangs genannten Art Stand der Technik. Beim Hohlguss-Verfahren wird normalerweise eine Gipsform, die die spätere Außenkontur des Tiegels exakt abbildet, mit der Schlickermasse gefüllt. Nach einer Zeitspanne von einigen Minuten bis Stunden, je nach der Zusammensetzung des Schlickers und der Größe der Form, hat sich an der Forminnenfläche eine feste Schicht mit mehreren mm Dicke abgesetzt. Der Rest an noch flüssigem Schlicker wird aus der Form entfernt und kann für einen nächsten Guss verwendet werden. Die in der Form verbleibende Schicht wird anschließend gesintert.

Die Form muss bei diesem Verfahren nicht komplett mit Schlickermasse gefüllt werden. Es reicht aus, die Form zum Teil zu füllen und durch eine Rotations- oder Schwenkbewegung dafür zu sorgen, dass die Oberfläche vollständig von der Schlickermasse benetzt wird (Schlämmen). So baut sich nach und nach eine entsprechende Schicht an der Formwand auf.

Eine weitere Variante besteht darin, eine Form, die die Innenkontur des herzustellenden Behälters formt, in einen geeigneten Behälter mit der Schlickermasse so lange einzutauchen, bis sich eine Schicht der gewünschten Dicke außen an der Form abgesetzt hat.

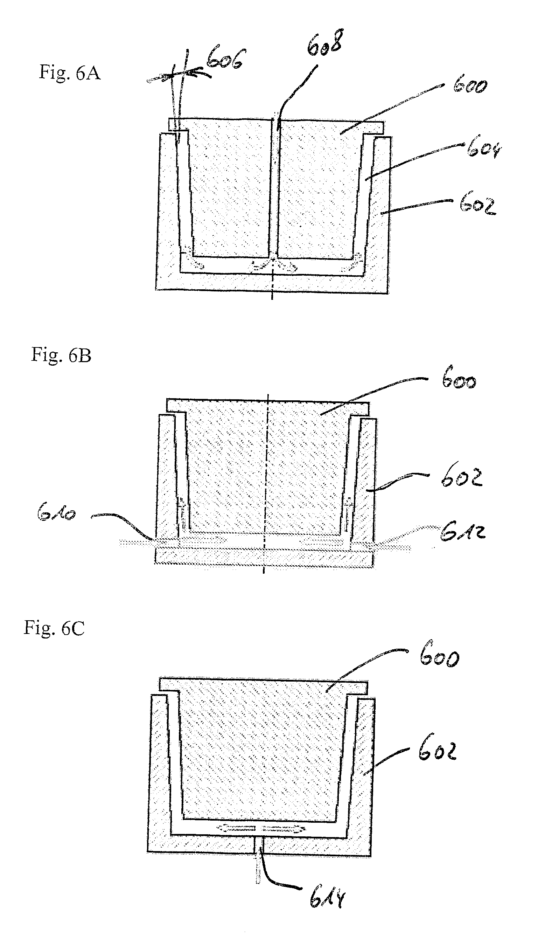

Das Gießen mit Kern ist in den Figuren 6A bis 6C dargestellt. Die Schlickergussform weist einen Kern 600 und eine Außenform 602 auf, zwischen denen ein spaltförmiger Formgebungsraum 604 ausgebildet ist, in welchen die Schlickermasse eingefüllt wird. Zur leichteren Entformung sind die Wände der Gussform konisch mit einem Winkel 606 ausgebildet. Die formgebenden Flächen der Gussform können bekanntermaßen mit einem Trennmittel versehen werden, um das Anhaften der getrockneten Schlickermasse zu verhindern. Als Trennmittel wird beispielsweise Graphitpulver oder Wachs verwendet. Die Schichtdicke darf die Wasseraufnahme der Form nicht oder nur unwesentlich behindern. Es muss also gewährleistet sein, dass die Poren der Gipsform nicht durch das Trennmittel verschlossen werden.

Solche Schlickergussformen können rund, quadratisch, rechteckig oder mehreckig ausgebildet sein. Sie weisen typischerweise einen Durchmesser von bis zu 1200 mm und einer Höhe von bis zu 1400 mm auf. Die durch den spaltförmigen Formgebungsraum 604 definierte Wanddicke des Behälters beträgt je nach Größe des herzustellenden Behälters zwischen 6 und 250 mm. Das Material der Schlickergussform ist typischerweise Gips oder in selteneren Fällen Ton.

In Figur 6A ist das Gießen mit einem zentral durchbohrten Kern dargestellt. Durch die zentrale Bohrung 608 wird die Schlickermasse in den Formgebungsraum eingefüllt. Eine gleichzeitige Entlüftung des Raums erfolgt durch den Spalt zwischen dem Kern 600 und der Außenform 602. Der Vorteil einer Beschickung der Form durch eine zentrale Bohrung in den Kern ist eine gleichmäßige Verteilung der Masse, die hohe Isotropie führt zu gleichmäßigem Schrumpfen beim Sintern. Der Nachteil dieser Gussform ist, dass der Schlicker einen langen Fließweg innerhalb der Gussform zurücklegen muss und dies eine entsprechend hohe Gießfähigkeit des Schlicks voraussetzt. Dies muss bei der Auslegung des Schlickers berücksichtigt werden.

Bei der Gussform gemäß Figur 6B wird der Schlicker durch wenigstens zwei oder mehrere, nach Möglichkeit symmetrisch um die Mantelfläche der Außenform 602 verteilte Öffnungen 110, 612 zugeführt. Die Entlüftung erfolgt ebenso wie zuvor durch den Spalt zwischen dem Kern 600 und der Außenform 602. Bei der einfachsten Variante erfolgt der Anguss an nur einer Ecke (nicht dargestellt). Hier ergeben sich ebenfalls sehr lange Fließwege und zudem eine ungleichmäßige bzw. unsymmetrische Füllung der Form. Dem gegenüber ist in dem gemäß Figur 6B dargestellten Fall das Problem gegeben, dass sich an den Stellen, an denen die einzelnen Materialströme zusammenfließen so genannte Fließfronten ergeben können. An diesen Stellen kann der Boden des so erzeugten Behälters inhomogen und besonders anfällig für Rissbildung und Bruch sein.

Eine weitere bekannte Ausführungsform ist in Figur 6C dargestellt, bei welcher der Schlicker durch eine zentrale Öffnung 614 im Boden der Außenform 602 erfolgt. Wiederum erfolgt die Entlüftung durch den Spalt zwischen dem Kern 600 und der Außenform 602. Die Vorteile und Nachteile sind ähnlich denen der Ausführungsform 6A, wobei die Fließwege in diesem Fall geringfügig verkürzt sind.

Es gibt weitere Ausführungsformen, bei denen eine im Grunde ähnlich aufgebaute Gussform über Kopf, das heißt mit einem unten angeordneten Kern und einer darüber gestülpten Außenform, beschickt wird. Hierbei sind zusätzlich zu den Beschickungsöffnungen Entlüftungsöffnungen im nun oben liegenden Bodenbereich der Außenform vorzusehen, da der Spalt zwischen Kern und Außenform nach unten gerichtet ist und durch die Schlickermasse gleich zu Beginn verschlossen wird.

Die sich aus dem Stand der Technik ergebenden Probleme sind zusammengefasst Lufteinschlüsse, welche insbesondere beim Zusammenfließen von Materialströmen ("Fließfronten") auftreten, weil dort die Luft nicht entweichen kann und im Material eingeschlossen wird. Ferner ist der so erzeugte Behälter an den Stellen der Fließfronten weniger belastbar, was zusätzlich durch eine Verunreinigung der Schlickermasse durch Einmischen von Trennmittelresten bedingt sein kann. Aufgrund der langen Fließwege ist eine erhöhte Fließfähigkeit notwendig. Zum Erreichen dieser Fließfähigkeit muss ein Mindestgehalt an Wasser im Schlicker enthalten sein, welches beim Trocknen der Masse entzogen wird. Hierdurch kann sich eine erhöhte Porosität bzw. eine geringe Materialdichte des erzeugten Behälters ergeben. Schließlich ist die Gefahr der Rissbildung aufgrund des Trocknens, insbesondere im Bereich von Materialanhäufungen in den Ecken oder im Bodenbereich des Behälters erhöht.

Aufgabe der vorliegenden Erfindung ist demnach verbesserte Quarzglasformkörper und ein Verfahren, eine Gussform bzw. eine Vorrichtung zur deren Herstellung zu schaffen, die eine zuverlässige Beschickung und einfache Entformung erlaubt und somit eine prozesssichere Herstellung der Quarzglasbehälter ermöglicht.

Die Aufgabe wird durch ein Verfahren mit den Merklmalen des Patentanspruchs 1, einen Quarzglasformkörper gemäß Patentanspruch 21, die Verwendung des Formkörpers nach Patentanspruch 27 und eine Gussform nach Patentanspruch 28 gelöst.

Das Verfahren der eingangsgenannten Art ist erfindungsgemäß dadurch gekennzeichnet, dass zumindest Teile der formgebenden Flächen der Innenform aus einer wasserdichten Substanz gebildet werden und dass während des Trocknens ein Überdruck auf das Quarzglas-Wassergemisch wirkt.

Zwar ist aus der WO 2006/089754 grundsätzlich sowohl die Verwendung eines Silikongummielements als Innenform und auch das Beaufschlagen der Außenform mit Druckluft bekannt. Ersteres geschieht dort jedoch, weil eine wasserabsorbierende Innenform bruchgefährdet ist und um eine leichtere Entformbarkeit zu erzielen. Die Druckluft wird erst nach dem Trocknen eingesetzt, um in bekannter Weise die Entformung zu erleichtern.

Die Erfindung setzt erstmals den Überdruck während des Trocknens in Kombination der wasserdichten formgebenden Fläche der Innenform, insbesondere aus Silikongummi und besonders bevorzugt aus Polyurethan (PU), ein. Die Erfinder haben herausgefunden, dass der während des Trocknens auf den Schlicker wirkende Überdruck zu der Innenform hin eine kompaktere und homogenere Struktur bewirkt und somit zu einer signifikanten Verringerung der Rissbildungsneigung beiträgt. Verantwortlich hierfür ist der Druck in dem Schlicker, der für eine hinreichend schnelle Abgabe des überschüssigen Wassers in Richtung der Außenform in der ersten Trocknungsphase sorgt, so dass sich Inhomogenitäten in Form charakteristischer "Wolkenstrukturen" in dem Material, die sich bei einem langsameren Wasserentzug einstellen, nicht ausbilden können. Ferner verringert sich der Fließwiderstand der Schlickermasse entlang der wasserdichten Oberfläche. Dadurch kann der Guss schneller und gleichmäßiger erfolgen, die Schlickermasse nimmt auf dieser Seite keine und insgesamt weniger Verunreinigungen, z.B. Trennmittelreste, Abrieb der Gussform (Gips, etc.)

auf. Dies führt zu einer besseren Qualität des fertigen Behälters. Ferner kann der Wasserentzug in eine Richtung gesteuert werden. Der Feinanteil der bei der Schlickerherstellung verwendeten Glaskörnung lagert sich bevorzugt an der Seite an, an das Wasser entzogen wird. Dort entsteht eine dichtere Oberfläche. Dieser Effekt beeinflusst jedoch die Rissbildungsneigung nicht negativ und spielt insbesondere bei der Tiegelherstellung für die Siliziumverarbeitung keine Rolle. In dem Wasser, das dem Schlicker entzogen wird, lösen sich Bestandteile des verwendeten Gipses und diffundieren in den Grünkörper. Dieser Effekt wird durch die wasserdichte formgebende Fläche auf der kritischen Innenseite ebenfalls vermieden. Die auf dieser Seite geformte Fläche des Quarzglasformkörpers (Tiegel, Behälter, Platte oder dergleichen) hat eine deutlich höhere Reinheit, insbesondere einen geringeren Gehalt an Alkali- und Erdalkalimetallen.

Ein Druckgefälle von innen nach außen steht dem Wasserentzug in Richtung der Außenform nicht entgegen, da die hierfür verantwortlichen Diffusions- und Kapillarkräfte wesentlich höher sind als die durch den Überdruck erzeugten Kräfte.

Ein weiterer Vorteil der Erfindung zeigt sich bezüglich der Reinheit des Formkörpers. Während die Reinheit (bzw. Verunreinigung) im gesamten Materialvolumen des Formkörpers gegenwärtig hauptsächlich durch die Reinheit des Rohmaterials bestimmt wird, beeinflusst der Gießprozess zusätzlich sehr stark die Verunreinigungen in dessen Oberflächenbereich, d.h. innerhalb einer Oberflächenschicht von etwa 2mm Dicke. Beides zusammen führt bei den bekannten Herstellungsverfahren zu Verunreinigungsgehalten an der Oberfläche von teilweise deutlich mehr als etwa 0,3 Gew..-% für Standard-Rohstoffe und deutlich mehr als etwa 0,2% für hochreine Rohstoffe. Der auf das Rohmaterial zurückzuführende Anteil der Verunreinigungen kann dabei für Standard-Rohstoffe mit weniger als 0,2 Gew-% und für hochreine Rohstoffe mit weniger als 0,1 % Gew.-% angegeben werden. Dies entspricht auch den Werten im Inneren der Formkörper. Das heißt aber auch, dass gerade beim Einsatz von teuren hochreinen Rohstoffen die Verunreinigung durch den Gießprozess besonders signifikant wird und der Reinheit des Formkörpers insgesamt Grenzen setzt.

Nun macht es das erfindungsgemäße Verfahren möglich den Gehalt an Verunreinigungen des erzeugten Formkörpers bedingt durch den Gießprozess gegenüber dem Stand der Technik erheblich zu senken. Es können mit dem erfindungsgemäßen Verfahren Formkörper erzeugt werden, die einen Verunreinigungsanteil im Oberflächenbereich von weniger als 0,2 Gew.-% und vorzugsweise weniger als 0,1 Gew.-% aufweisen. Je nach Rohstoffqualität beträgt die Verunreinigung im Oberflächenbereich sogar weniger als 0,07 Gew.-% und bei besonders sorgfältiger Anwendung des erfindungsgemäßen Verfahrens sogar weniger als 0,04-Gew% nachgewiesen werden. Der Gehalt an Verunreinigungen wird hierbei an einer Oberflächenschicht von etwa 2mm Dicke bestimmt, die abgetragen und auf ihre Bestandteile hin analysiert wird.

Bei der Verkleidung handelt es sich bevorzugt um glatte wasserdichte Schichten.

Die aus der wasserdichten Substanz gebildeten formgebenden Oberflächen können durch Verkleidung einer Gipsform mit Zuschnitten wasserdichter Matten erfolgen. Die Gussform kann in einer anderen vorteilhaften Ausführungsform mit einer aus der wasserdichten Substanz vorgefertigten, bevorzugt einstückigen Form verkleidet werden. Hiezu bieten sich insbesondere vorgefertigte Spritzgussformen aus Kunststoff, besonders bevorzugt aus Silikongummi oder PU an.

Gemäß einer alternativen Ausführungsform wird die Gussform zumindest teilweise mit der wasserdichten Substanz beschichtet. Dies kann durch Ausschlämmen, Ausgießen oder Ausschäumen geschehen. Als wasserdichte Beschichtung bietet sich beispielsweise Bienenwachs an, welches so dick aufgetragen werden muss, dass die Schicht wasserdicht ist, dass also die Poren in der Gussform verschlossen sind. Ferner können als wasserdichte Beschichtung auch Lacke auf die Gussform aufgetragen werden. Sowohl Lacke auf Kunstharzbasis als auch auf Acrylbasis können hierfür verwendet werden.

Eine anderen alternative Ausgestaltung des Verfahrens besteht darin, bei einer Gussform mit einer Außenform und einer Innenform letztere aus einem brennbaren Werkstoff herzustellen, der im späteren Sinterprozess verbrannt wird. Bei dem brennbaren Werkstoff kann es sich um einen Kunststoff wie Styropor oder vorzugsweise PU-Schaum handeln. Ferner können auch natürliche Werkstoffe wie Maispads zum Einsatz kommen. Auf diese Weise kann auf eine manuelle Entformung des Kernes verzichtet werden, wodurch der Herstellungsprozess vereinfacht und somit kostengünstiger wird. Ferner kann hierdurch auch die Entformungsschräge entfallen und es können sogar Innenkonturen mit Hinterschneidungen verwirklicht werden und es entsteht weniger Ausschuss durch Zerstörung beim Entformen.

Alle Ausgestaltungen der wasserdichten Formflächen erlauben die Herstellung von Tiegeln, die insbesondere auf Ihrer Innenseite Oberflächenstrukturen aufweisen, die zur Anhaftung einer Beschichtung, z.B. einer Pulverbeschichtung oder einer Emulsion geeignet sind. Zu diesem Zweck können Verkleidungen mit komplementären Strukturen eingesetzt werden.

Neben dem Überdruck, der während des Trocknens auf das Quarzglas-Wassergemisch wirkt, kann eine Druckdifferenz auch bereits während des Einbringens des Quarzglas-Wassergemisches und/oder während des Entformens über die Gussform angelegt werden, indem die Gussform beispielsweise einem Über-oder Unterdruck ausgesetzt wird. Durch das Druckbeaufschlagen des Schlickers schon beim Einbringen kann dieser Vorgang beschleunigt werden. Dasselbe gilt für das Anlegen eines Unterdruckens über die Gussform.

Ein weiterer Vorteil ergibt sich beim Entformen der Grünlinge: Durch das Anlegen von Überdruck kann der Grünling einfacher aus der Form gelöst werden. Zum Ziehen der Innenform kann beispielsweise an der Außenform ein Unterdruck angelegt und an der Innenform ein Überdruck eingestellt werden. So kann der Winkel einer Entformungsschräge minimiert werden. Ebenso können umgekehrte Druckverhältnisse geschaffen werden, um den Grünling aus der Außenform zu lösen.

Der Formkörper im Sinne der Erfindung ist nicht auf eine bestimmte Form eingeschränkt. Der Formkörper kann eine flache Platte sein. Aus mehreren solcher Platten können dann beispielsweise Schmelztiegel zusammengesetzt werden. Als "Innenform" ist in diesem Fall der Abschnitt der Gussform zu verstehen, dessen formgebende Fläche die mit dem Schmelzgut in Berührung kommende Fläche se Formkörpers bildet. Die Gussform ist jedoch bevorzugt zur Herstellung eines Quarzglastiegels als Formkörper eingerichtet, indem sie einen Kern als Innenform und eine Außenschale als Außenform aufweist, wobei das Quarzglas-Wassergemisch unter Ausnutzung der Schwerkraft von einem Niveau oberhalb des oberen Tiegelrandes, auf welchem ein Einfüllstutzen (Trichter oder Behälter) der Gussform angeordnet ist, durch eine Einlassöffnung in der Gussform im Tiegelbodenbereich, die über eine Schlauch oder Rohrverbindung mit dem Einfüllstutzen verbunden ist, eingebracht wird. So können einstückige Tiegel hergestellt werden, die zusammengesetzten Tiegeln aus Gründen der Dichtigkeit vorgezogen werden.

Dabei hat es sich als günstig im Hinblick auf eine geringe Rissbildung herausgestellt, wenn die Einlassöffnung im Bereich des Übergangs vom Tiegelboden zu den Tiegelwänden, also in den Bereichen von Kanten und besonders bevorzugt in den Bereichen von Ecken angeordnet ist.

Der vorzugsweise auf dieselbe Weise erzeugte hydrostatische Druck kann dann auch als Überdruck genutzt werden, der während des Trocknens auf das Quarzglas-Wassergemisch wirkt, um die gewünschte Homogenisierung und Verdichtung des Schlickers zu erreichen. Der hydrostatische Druck lässt sich einfach durch die Wahl der Füllhöhe über dem oberen Tiegelrand einstellen.

Die Gussform weist in einer alternativen Ausgestaltung Hohlräume im Bereich der Außenform in Form eines Kanalsystems und wenigstens ein Anschlussmittel zum Anschließen eines Druckmittels, bevorzugt Druckluft, auf. Sie wird mit einem Überdruck beaufschlagt. Das Kanalsystem ist vorzugsweise in Form wenigstens eines in die Gussform eingelassenen Gewebeschlauchs ausgebildet. Dies lässt sich leicht herstellen, indem der Gewebeschlauch in die Gipsform eingegossen wird. Das Kanalsystem sollte möglichst nahe unter der formgebenden Oberfläche der Gussform verlaufen, ohne deren Stabilität zu gefährden. Auf diese Weise liegt die Druckdifferenz nur über eine kurze Distanz an und der Druckgradient ist vergleichsweise hoch. Dies erhöht die Effizienz der Vorrichtung insbesondere bei einem hohen relativen Strömungswiderstand des Gussformmaterials.

Der über das Kanalsystem angelegte Überdruck kann auch in vorteilhafter Weise mit dem hydrostatischen Druckprinzip kombiniert werden.

Auf die ein oder andere Weise wird bevorzugt ein Überdruck erzeugt, der mit 0,02 bar bis 1,4 bar und besonders bevorzugt zwischen 0,1 bar und 0,2 bar über dem Normaldruck auf die Schlickermasse wirkt.

Da die Rissbildung verstärkt auftritt, wenn der Feststoffgehalt erhöht bzw. der Wassergehalt gesenkt wird, konnte bei den bekannten Verfahren typischerweise nur mit Feststoffgehalten zwischen 70% und 85% in der Schlickermasse gearbeitet werden. Das beim Trocknen austretende Wasser hinterlässt jedoch unerwünschte Poren oder Lufteinschlüsse in dem fertig getrockneten Quarzglasmaterial, deren Größe und Häufigkeit mit dem ursprünglichen Wassergehalt zunimmt und die ebenfalls die Stabilität des Formkörpers gefährden.

Mit dem erfindungsgemäßen Verfahren ist es nunmehr möglich einen Formkörper aus einem Quarzglas-Wassergemisch herzustellen, das beim Einbringen in die Gussform einen Wassergehalt von 15% Gew.-% oder weniger aufweist. Im Hinblick auf eine möglichst niedrige offene Porosität des Formkörpers ist ein niedrigerer Wassergehalt von höchstens 12 Gew.-%, bevorzugt höchstens 10 Gew.-% und ganz besonders bevorzugt höchstens 7 Gew.-% erstrebendwert. Ein niedriger Wassergehalt geht zu Lasten der Verarbeitbarkeit, die aber aufgrund des erfindungsgemäßen Verfahrens jeweils ohne Zugabe von Fließverbesserern (zum Beispiel Polyethylenglykol oder Methylcellulose) noch bis zu einem Wassergehalt von 5 Gew.-% als Untergrenze sichergestellt ist. Fließverbesserer sind insbesondere bei der Schmeiztiegelherstellung zu vermeiden. Ihr Einsatz lässt sich anhand von Restkohlenstoff oder solchen enthaltende Verbindungen in dem fertigen Tiegel auch nach dem Sintern nachweisen. Dieser Restkohlenstoff sorgt für eine unerwünschte Gasbildung im Einsatz der Tiegel, d.h. in der Si- oder Glasschmelze, je nachdem wofür der Teigel eingesetzt wird. Die Gasbildung führt dann zu einer Erhöhung der Blasenanzahl in dem Schmelzprodukt und/oder behindert allgemein dessen Erstarrungprozess. Ein guter Kompromiss zwischen Verarbeitbarkeit und Porosität stellt sich bei einem Wassergehalt zwischen 9,5 und 11,5 Gew.-% ein.

Der getrocknete Formkörper weist im Ergebnis deshalb trotz geringer Rissbüdungsneigung einen wesentlich geringeren Gehalt an Lufteinschlüssen oder Poren auf. Der Porengehalt eines so erzeugten Formkörper beträgt erfindungsgemäß weniger als 15 Vol.-% , vorzugsweise weniger als 10 Vol.-% und besonders bevorzugt weniger als 8 Vol.-% und das zugleich ohne Kohlenstoffrückstände durch den Einsatz von Fließverbesserern.

Als vorteilhaft hat sich erwiesen, wenn die Gussform unter Überdruck über eine Zeitspanne von nicht mehr als einer Stunde vollständig befüllt wird. Die Fülldauer kann je nach Menge des benötigten Quarzglas-Wassergemisches variieren und so kurz wie möglich zu halten. Bevorzugt liegt sie zwischen 10 Minuten und 30 Minuten. Bei sehr kleinen Tiegeln kann das Befüllen auch im Bereich von 5 Minuten liegen, bei sehr großen Tiegeln bis zu 1 Stunde dauern. Für Tiegelmaße mit Kantenlängen im Bereich von 400 mm und 750 mm und einer Höhe zwischen 270 mm und 500 mm und bei einer bevorzugten Wanddicke zwischen 8 mm und 35 mm wird eine Fülldauer von etwa 30 Minuten angestrebt.

Gemäß einer vorteilhaften Weiterbildung des erfindungsgemäßen Verfahrens wirkt während einer ersten Phase des Trocknens der Überdruck auf das Quarzglas-Wassergemisch. Während einer zweiten Phase des Trocknens wird die Innenform von dem angetrockneten Grünkörper abgehoben. Dies geschieht bei einer Gussform für Tiegel, indem der Kern ein Stück gezogen wird, so dass er das in der ersten Phase vorgetrocknete und bereits stabilisierte Material nicht mehr berührt. Er schließt die Form aber noch ab, so dass eine Konvektion der Raumluft vermieden wird. Diese würde nämlich ein zu schnelles Trocken der Oberfläche und als Ergebnis eine hohe Rissbildungsgefahr bewirken. Zweck ist in erster Linie, dass ein durch Schrumpfung des Formkörpers bewirktes Anhaften an der Innenform vermieden und so die Bruchgefahr bei der Entformung vermindert wird. Die Außenform liegt dicht an dem bereits verfestigten Formkörper an, so dass ein Überdruck über die Außenform aufrecht erhalten werden kann.

Bevorzugt dauert die erste Phase des Trocknens, in der der Kern komplett in der Form verankert ist und mit dem Schlicker in Berührung steht, zwischen 2 und 24 Stunden an. Für Tiegelmaße mit Kantenlängen im Bereich von 400 mm und 750 mm und einer Höhe zwischen 270 mm und 500 mm und bei einer Wanddicke zwischen 8 mm und 35 mm beträgt die bevorzugte Dauer der ersten Trockenphase etwa 10 Std.

Die zweite Phase des Trocknens dauert bevorzugt zwischen 10 Stunden und 12 Tagen an. Für vorgenannte Tiegelgröße ist die zweite Trockenphase besonders bevorzugt zwischen 36 Stunden und 3 Tagen lang, bei sehr kleinen Tiegel genügen zwischen 10 und 24 Stunden. Bei sehr großen Tiegeln bzw. bei Tiegeln mit sehr hoher Wanddicke (>35mm) kann die Dauer bis zu 12 Tagen und in Ausnahmen auch länger betragen. Danach werden die Rohlinge aus der Form entnommen und gebrannt.

Unterstützend kann die Gussform beim Einbringen des Quarzglas-Wassergemisches in Schwingung versetzt wird. Die Vorrichtung zur Herstellung von Quarzglasbehältern weist neben der Gussform entsprechend bevorzugt eine Rüttelvorrichtung auf, die zur Aufnahme und Bewegung der Gussform eingerichtet ist.

Die Füllung der Formen kann durch Vibration der gesamten Form deutlich verbessert werden. Der gesamte Formenaufbau wird dabei auf einem Rütteltisch aufgebaut und zu Schwingungen angeregt.

Die Füllung der Formen kann dadurch deutlich verbessert werden. Die Anzahl von Poren wird deutlich reduziert. Das Verfahren ist insbesondere dann vorteilhaft, wenn großflächige Teile mit geringer Wanddicke hergestellt werden sollen und wenn allgemein die Dichte und Porosität des Materials verringert werden soll.

Vorzugsweise liegt die Schwingungsfrequenz zwischen 0,1 Hz und 25 Hz, besonders bevorzugt zwischen 1 Hz und 5 Hz. Die Schwingungsamplitude liegt vorzugsweise zwischen 0,25 mm und 20 mm und besonders bevorzugt zwischen 1 mm und 3,5 mm.

Der optimale Frequenzbereich und die optimale Amplitude hängen von der Bauteilgröße, dem Oberflächen-Wanddicken-Verhältnis des Bauteils sowie von der Art des Schlickers, z.B. von der Größenverteilung der Ausgangs-Glaskörnung, dem Wassergehalt und dem Spurenelementgehalt an Alkalien, und von dem Gewicht der Form incl. Füllgewicht ab. Insbesondere können Amplituden über 20 mm führen zur Zerstörung der Form führen, während Amplituden unter 0,25 mm wenig wirksam sind.

Das Schwingen oder Rütteln der Gussform kann vorteilafterweise mit einem Verfahren nach dem ersten Aspekt der Erfindung, nämlich dem Verkleiden mit einer wasserdichten Substanz, und/oder einem Verfahren gemäß dem zweiten Aspekt der Erfindung, nämlich der Verwendung einer Druckdifferenz, kombiniert werden.

In besonderen Fällen kann bei einer Gussform mit einer Außenform und einem Kern zunächst unter Bildung einer ersten Schicht ein erster Teil des Quarzglas-Wassergemisches der Oberfläche der Außenform oder des Kerns angetrocknet und anschließend die Gussform einschließlich der ersten angetrockneten Schicht zusammengesetzt wird, bevor ein zweiter Teil des Quarzglas-Wassergemisches in den verbleibenden Formgebungsraum der Gussform eingebracht und anschließend zu einer zweiten Schicht getrocknet wird.

Auf diese Weise erfolgt das Gießen des Quarzglastiegels auf ökonomisch günstige Weise in einem zweistufigen Prozess, wobei wahlweise die Tiegelinnenschale oder die Tiegefaußenschale bereits mittels der Innen- oder Außenform der Gussform erzeugt und zusammen mit dieser zu der geschlossenen Gussform zusammengesetzt wird bevor der Quarzglastiegel fertig gegossen wird. Hierbei kann entweder zunächst die Außenform befüllt und nach Bildung einer festen, wasserarmen Randschicht an der Innenwand der Außenform der flüssige Rest Schlicker ausgegossen werden, um die erste Schicht zu formen. Alternativ kann der Prozess auch umgekehrt werden, indem zunächst der Kern in einen Behälter mit Schlickermasse eingetaucht bzw. mit Schlickermasse umspült wird, bis sich um diesen herum eine feste, wasserarme Randschicht gebildet hat.

Je nach Anwendung können die ersten und zweiten Teile des Quarzglas-Wassergemisches unterschiedliche Zusammensetzungen haben. Zum Beispiel kann der auf der Innenseite des Quarzglas-Behälters verwendete Schlicker eine höher Reinheit oder eine feinkörnigere Struktur aufweisen, um eine ebenfalls bessere Oberflächegüte und/oder reinere Zusammensetzung der in dem Quarzglas-Behälter zu schmelzenden Substanz zu erzielen.

Insbesondere kann auf diese Weise ein kostengünstiger und dennoch wenig verunreinigender Tiegel hergestellt werden, wenn auf dessen Innenseite Rohstoffe besonders hoher Reinheit verwendet werden und für die Außenseite kostengünstigere, herkömmliche Rohstoffe zum Einsatz kommen. So ist es mit dem erfindungsgemäßen Verfahren möglich einen Tiegel kostengünstig herzustellen, der in Kombination mit der Verbesserten Oberflächenreinheit aufgrund der Verkleidung der Gussform trotz überwiegender Verwendung des günstigeren Rohmaterials (Standard-Rohmaterial) für den Außenbereich des Behälters oder Tiegels eine sehr reine Schmelzgut-Kontaktseite aufweist.

Auch kann es vorteilhaft sein, die Tiegelinnenschale aus einer Schicht zu bilden, deren Zusammensetzung Zusätze von Silizium und/oder Siliziumnitrid von 0,1 Gew.-% bis 8 Gew.-% enthält, also deutlich über einem Anteil möglicher Verunreinigungen jedoch unter einem Anteil, bei dem Gießprozess instabil wird. Bevorzugt liegt der Anteil von Silizium und/oder Siliziumnitrid bei mindestens 0,15 Gew.-% und nicht höher als 5 Gew.-%. Besonderes bevorzugt sind nicht mehr als 2 Gew.-% und ganz besonders bevorzugt nicht mehr als 1 Gew.-% Silizium und/oder Siliziumnitrid enthalten.

Bevorzugt kann nach Bildung der ersten Schicht diese zumindest abschnittsweise mit einer Zwischenschicht belegt werden. Die Zwischenschicht besteht bevorzugt aus einem Fasergelege, -Gewebe, - Gewirke, -Geflecht oder -Filz. Die Zwischenschicht enthält bevorzugt Fasern der Gruppe Glasfasern, Kohlenstofffasern, Metallfasern, keramische Fasern. Als keramische Fasern kommen zum Beispiel Siliziumcarbid-Fasern oder Aluminiumoxid-Fasern in Betracht. Die Zwischenschicht kann auch aus einem Metallgitter bestehen.

Insgesamt kann durch eine solche Zwischenschicht die Belastbarkeit des Quarzglasbehälters erhöht werden, ohne an der Zusammensetzung des Schlickers Änderungen vornehmen zu müssen und insbesondere ohne eine höhere Porosität des Schlickers in Kauf nehmen zu müssen. Insbesondere in Bereichen besonders hoher Lasten, beispielsweise in Ecken des Behälters oder im Bodenbereich des Behälters kann auf diese Weise eine gezielte Verstärkung vorgenommen werden. Umgekehrt kann die Wandstärke des Behälters bei gleich bleibender Belastbarkeit verringert werden.

Aufgrund der eingeschränkten Fließfähigkeit des Quarzglas-Schlickers ist der Einsatz von Mehrfachformen bisher nur eingeschränkt möglich. Für Behälter ab Größen 650mm x 650mm x 350 mm mit Wanddicken in den Behälterflächen von weniger als 28 mm führt die Verwendung von Mehrfachformen zu einer deutlich schlechteren Behälterqualität bzw. zu einer verminderten Ausbeute. Dies ist begründet durch die langen Fließwege. Aufgrund des sofort beginnenden Wasserentzugs verliert die Fließfront schnell an Fließfähigkeit. Durch einen höheren Wassergehalt im Schlicker kann dies zwar ausgeglichen werden. Dann ist aber die Schrumpfung des Schlickers beim Trocknen so groß, dass Schrumpfrisse entstehen.

Das erfindungsgemäße Verfahren und die erfindungsgemäße Vorrichtung erlauben nun die Herstellung von Quarzglastiegeln, die bei Abmessungen von 550 mm Länge, 550 mm und 350 mm Höhe oder mehr Wanddicken von weniger als 20 mm, vorzugsweise weniger als 18 mm, insbesondere weniger als 15 mm und sogar weniger als 12 mm und eine Bodendicke von weniger als 24 mm, vorzugsweise weniger als 20 mm, insbesondere weniger als 18 mm und bei besonderer Sorgfalt und sogar weniger als 15 mm manchmal sogar 12 mm aufweisen.

Nachweislich lassen sich mit dem erfindungsgemäßen Verfahren bei den genannten Wandstärken erstmals sogar Tiegelgrößen mit den folgenden Abmessungen erreichen:

1.

720 mm x720 mm x 500 mm

2.

850 mm x 850 mm x 600 mm

3.

1200 mm x 1200mm x 650 mm

Durch zuvor beschriebene Erfindungsaspekte können nun auch Mehrfachformen so eingesetzt werden, dass der Gesamtprozess wirtschaftlich besser betrieben werden kann.

Weitere Aufgaben, Merkmale und Vorteile werden nachfolgend anhand von Ausführungsbeispielen mit Hilfe der beigefügten Zeichnungen näher erläutert:

Fig. 1          eine erste Ausführungsform der erfindungsgemäßen Form mit verkleidetem Kern;

Fig. 2          eine zweite Ausführungsform der erfindungsgemäßen Gussform mit verkleideter Außenform;

Fig. 3          eine dritte Ausführungsform der erfindungsgemäßen Gussform mit Kanalsystem;

Fig. 4A -4C     eine schematische Darstellung des Herstellungsverfahrens eines mehrschichtigen Quarzglas-Behälters;

Fig. 5          eine Mehrfachgussform und

Fig. 6A-6C      eine schematische Darstellung des Schlickerguss-Formgießens nach dem Stand der Technik.

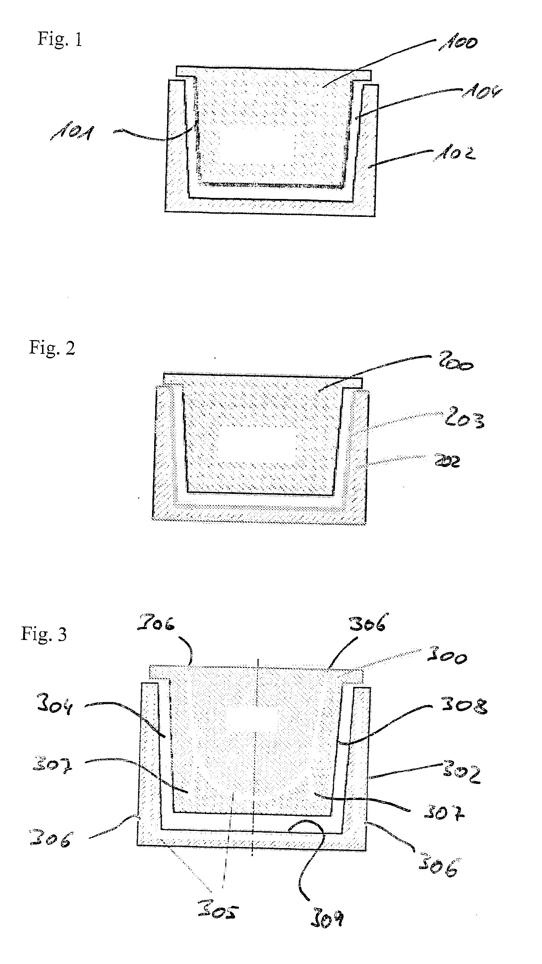

Figur 1 stellt eine erfindungsgemäße Gussform im Schnitt dar. Die Gussform ist zweiteilig ausgeführt und weist einen Kern 100 sowie eine Außenform 102 auf. Zwischen Kern 100 und Außenform 102 ist der Formgebungsraum 104 ausgebildet. Der Kern ist mit einem einstückigen Überzug 101 verkleidet. Der Überzug 101 besteht aus einem wasserdichten Material. Er entspricht der Kontur des Kerns 100 und wurde in dieser Form beispielsweise in einem Spritz-Gussverfahren vorgefertigt. Als bevorzugtes Material des Überzugs 101 kommt Silikongummi in Betracht. Hierbei weist ein Silikongummiüberzug mit einer Dicke von 5 mm und einer Härte von 60 Shore A eine ausreichende Festigkeit für die gedachte Anwendung auf.

Die Gussform gemäß Figur 2 ist ebenfalls im Schnitt dargestellt und weist einen Kern 200 sowie eine Außenform 202 auf. In diesem Fall ist allerdings nicht der Kern sondern die Außenform 202 mit einer vorgeformten Ausschalung 203 verkleidet. Diese Ausschalung 203 ist wiederum einstückig vorgefertigt und besteht vorzugsweise ebenfalls aus Silikongummi mit einer bevorzugten Dicke von ca. 5 mm und einer Härte von ca. 60 Shore A. Die Materialstärke und Härte der Silikongummiausschalung bzw. des Silikongummiüberzugs kann je nach Größe der Gussform zwischen vorzugsweise 3 mm und 7 mm bzw. zwischen vorzugsweise 40 Shore A und 80 Shore A variieren. Geringere und höhere Härten sind zwar prinzipiell möglich, weisen aber im Prozess Nachteile hinsichtlich der Verarbeitbarkeit, Haltbarkeit und des Fließverhaltens des Schlickers auf.

In Figur 3 ist eine Ausführungsform der erfindungsgemäßen Gussform gemäß dem zweiten Aspekt der Erfindung im Schnitt dargestellt. Die Gussform weist wiederum einen Kern 300 und eine Außenform 302 auf. Sowohl im Kern 300 als auch in der Außenform 302 sind Kanäle 305 angeordnet. Diese Kanäle münden in Öffnungen 306 jeweils auf der Außenseite des Kerns 300 bzw. der Außenform 302 und weisen dort (nicht gezeigte) Anschlussmittel zum Verbinden mit einer Pumpeinrichtung auf. Auf diese Weise können die Kanäle mit einem Über- bzw. Unterdruck beaufschlagt werden. Durch die Druckdifferenz wird eine Strömungsrichtung des Fluids, bevorzugt Luft, vorgegeben. Erfindungsgemäß wird gemessen am Normaldruck ein Überdruck von 0,02 bar bis 1,4 bar bzw. eine Unterdruck von 0,01 bar bis 0,9 bar eingestellt.

Die Kanäle werden bevorzugt in Form von Textilschläuchen in die Gussform bei deren Herstellung eingegossen. Sie verlaufen, wie in Figur 3 zu erkennen ist, nahe den formgebenden Oberflächen 308 und 309 des Kerns 300 bzw. der Außenform 302, um das Druckgefälle möglichst effizient in der Umgebung des Formgebungsraums 304 zu erzeugen. Zusätzlich sind in der dargestellten Ausführungsform Abzweigungen 307 von den Kanälen 305 vorgesehen, welche in den Ecken des Kerns 300 enden, um auch dort möglichst nahe der formgebenden Oberfläche 308 einen Über- bzw. Unterdruck zu erzeugen.

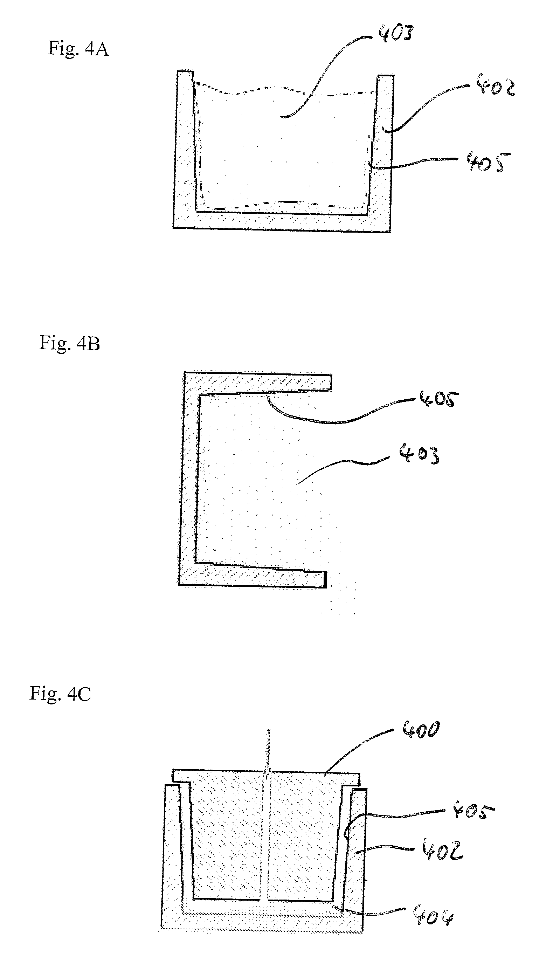

In Figuren 4A bis 4C ist in drei Schritten das Verfahren eines wenigstens aus zwei Schichten bestehenden Quarzglasbehälters skizziert. In Figur 4A (Schritt 1) ist Außenform 402 des Gussbehälters mit der Schückermasse 403 gefüllt, welche bereits nach einer kurzen Zeit von einigen Minuten bis Stunden im Randbereich 405 angetrocknet ist, weil dort der Schückermasse das in den Gips der Außenform 402 diffundierende Wasser entzogen ist.

Hiernach wird gemäß Figur 4B die noch flüssige Rest-Schlickermasse 403 aus der Außenform ausgegossen (Schritt 2). Die feste, wasserarme Randschicht 405 verbleibt in der Außenform und bildet eine erste Schicht des Quarzglas-Behälters. Die ausgegossene noch flüssige Schlickermasse 403 kann für den nächsten Guss weiter verwendet werden.

In Figur 4C ist die Gussform bestehend aus der Außenform 402 und dem Kern 400 zusammengesetzt dargestellt. Der zwischen der angetrockneten ersten Schicht 405 und dem Kern 400 der Gussform verbleibende Formgebungsraum 404 wird dann mit einem zweiten Teil des Quarzglas-Wassergemisches aufgefüllt und getrocknet (Schritt 3). Dabei kann die Zusammensetzung des ersten Teils und des zweiten Teils des Quarzglas-Wassergemisches unterschiedlich sein. Außerdem kann vor dem Zusammensetzen der Gussform auf die erste Schicht eine Zwischenschicht, insbesondere in mechanisch hoch belasteten Bereichen aufgelegt werden. Diese Zwischenschicht kann wie zuvor beschrieben, aus einem Faser-Gelege, -Gewebe, -Gewirke, -Geflecht oder-Filz bestehen und aus unterschiedlichen Fasern hergestellt sein. Eine Zwischenschicht ist in Figur 4C nicht dargestellt.

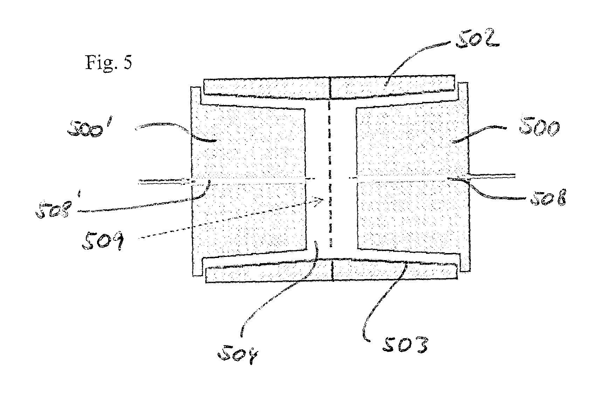

In Figur 5 ist beispielhaft eine so genannte Zwillingsform als Mehrfachgussform im Schnitt dargestellt. Diese Gussform weist eine Außenform 502 sowie beidseits jeweils einen Kern 500 und 500' auf, mit der die Außenform verschlossen ist. Die Außenform ist ferner entlang ihrer inneren Mantelfläche gemäß dem ersten Aspekt der Erfindung mit einer Silikonauskleidung 503 verkleidet. Beide Kerne weisen zentrale Bohrungen 508 bzw. 508' auf, durch die der Formgebungsraum 504 befüllt wird. Auch der Wasserentzug erfolgt über den Kern, da die Außenform mit der wasserdichten Verkleidung 503 keine oder nur eine geringe Diffusion des Wassers in den Gips zulässt. Wenig Diffusion ist dann möglich, wenn die Verkleidung perforiert ist.

Nach dem Entformen wird der Grünling entlang der gestrichelt dargestellten Trennlinie 509 mittels einer Säge zum Beispiel einer Seilsäge, in zwei Behälter getrennt.

Die Mehrfach-Form gemäß Figur 5 lässt sich vorteilhafterweise noch mit einem Kanalsystem wie in Figur 3 vorgestellt kombinieren. Eine Druckdifferenz bzw. eine Über- und/oder Unterdruck kann allerdings ebenfalls ohne Kanalsystem angelegt werden, in dem beispielsweise an einer oder an beiden stirnseitigen Außenflächen eines bzw. beider Kerne 500, 500' eine großflächige Saugvorrichtung (Saugglocke) angeschlossen wird. Hierbei werden allerdings größere Strömungswege durch den Kern und damit ein größerer Druckverlust über den Kern in Kauf genommen. Auch ist die Druckdifferenz entlang der formgebenden Oberfläche des Kerns ist bei einem Verzicht auf ein Kanalsystem stark unterschiedlich.

Für die beschriebenen Verfahren eignen sich Schlickermassen, die auf Korngrößen von unter 10,2 mm aufgebaut sind. Körner über 10,2 mm dürfen nur geringen Mengen vorhanden sein, weil diese den Gießprozess stören.

Die in Tabelle 1 angegebenen Schlickermassen eignen sich beispielsweise zum Vergießen in einem der zuvor beschriebenen erfindungsgemäßen Verfahren. Angegeben sind jeweils die Korngrößenverteilung und der Wassergehalt des Schlickers vor dem Gießen. Die Angaben sind jeweils in Gew.-% der Gesamtmasse.

Tabelle 1

| Korngröße | Masse 1 | Masse 2 | Masse 3 | Masse 4 | Masse 5 | Masse "Gesamt" |
|---|---|---|---|---|---|---|
| kleiner 0,3 mm | 37,0 bis 67,5% | 37,0 bis 67,5% | 9 bis 10% | 28 bis 40% | 4 bis 38% | 4 bis 80,5% |
| 0,3 bis 1,0 mm | 28 bis 59 % | 17,5 bis 52% | 76 bis 80% | 21 bis 66% | 20 bis 80% | 17,5 bis 80% |
| 1,0 bis 3,0 mm | 4 bis 8% | 0 bis 20% | 10 bis 15% | 0 bis 48% | 5 bis 45% | 0 bis 48% |
| 3,0 bis 6,0 mm | < 1 % | 0 bis 15% | 0% | <1 % | 0 bis 14% | 0 bis 15% |
| 6,0 bis 10,2 mm | < 1 % | <2% | 0% | 0% | < 2 % | < 2 % |
| Wassergehalt d. Schlickers (bezogen auf das Gewicht des Glasanteils) | 7 bis 15% | 8 bis 15 % | 8 bis 15% | 9 bis 15% | 7 bis 15% | 7 bis 15% |

Für eine Schlickermasse mit der Korngrößenverteilung wie die der Masse 1 konnte in Abhängigkeit von dem Wassergehalt folgende Porosität des Formkörpers nach dem Brennen bei einer Brenntemperatur von 1150°C in Volumenprozent festgestellt werden:

15% Wassergehalt: offene Porosität 11,0% bis 14,7%,
12% Wassergehalt: offene Porosität 9,7% bis 13,3%,
10% Wassergehalt: offene Porosität 8,0% bis 12,2%,
7% Wassergehalt: offene Porosität 5,8% bis 10,2%.

Nachdem Formkörper mit offensichtlichen Risse schon vor dem Sintern ausgesondert wurden, wurde die Rissbildung an gesinterten

Formkörpern in zwei Untersuchungsschritten ermittelt: Im ersten Schritt wurden die Formkörper im Durchlichtverfahren optisch auf Risse inspiziert. Wenn Risse erkennbar waren, wurden die Formkörper als Ausschuss ausgesondert. In einem zweiten Schritt wurden die Formkörper einer Röntgenuntersuchung unterzogen. Hierbei können Risse in den Kanten- und Eckbereichen und solche, die kleiner als 20mm lang sind und im Durchlichtverfahren nicht erkennbar waren, entdeckt werden. Ferner macht das Röntgenbild Inhomogennitäten sichtbar, die durch teilweise Entmischung des Schlickers aufgrund zu langsamen Wasserentzugs in der ersten Trocknungsphase entstanden waren. Solche Inhomogenitäten oder "Wolkenstrukturen" können zu einer späteren Rissbildung im Einsatz des Tiegels führen. Bei der Siliziumschmelze wird der Tiegel bei etwa 1200°C eingesetzt. In diesem Temperaturbereich findet eine Umwandlung des Tiegelmaterials in Cristobalit statt, die zu eine Schrumpfung führt des Tiegel führt. Inhomogenitäten wirken sich dann in sofern negativ aus, als sie zu nachträglicher Rissbildung führen können, wodurch die Siliziumschmelze auslaufen könnte. Formkörper, bei denen in diesem Schritt Risse oder Inhomogenitäten erkennbar wurden, wurden deshalb ebenfalls als Ausschuss ausgesondert.

Mit in einem herkömmlichen Verfahren, bei dem sowohl die Außenform als auch der Kern aus Gips mit einer Graphitbeschichtung auf den Formgebenden bestand und bei dem das Schlickermaterial über eine oben liegende Einlassöffnung in der Gussform zugeführt wurde, konnten aus in Tabelle 1 angegebenen Masse 1 keine für die Siliziumschmelze verwertbaren Tiegel ohne Risse erzeugt werden.

Nachdem eine Gussform mit einer Einlassöffnung in der Ecke des Bodenbereiches gewählt wurde, erhöhte sich die Ausbeute rissfreier Tiegel auf 30%. Die Auswertung der Röntgenbilder zeigte schon vor dem Sintern, dass bei der herkömmlichen Gusstechnik Materialentmischung und Agglomerationen erkennbar wurden, die spätestens beim Sintern Risse oder Mikrorisse entstehen lassen, weil die unterschiedliche Korngrößenverteilung zu unterschiedlicher Schrumpfung führt.

Es zeigte sich, dass erst durch das erfindungsgemäße Verfahren mit Druckbeaufschlagung während des Trocknens und wasserdichten formgebenden Oberflächen des Kerns eine befriedigende Ausbeute von wenigstens 90% erzielbar wurde. Dies ist auf eine sehr gleichmäßige Materialstruktur und ein effektives Verhindern der Entmischung des Materials zurückzuführen.

Die Verfahrensparameter der Formkörperherstellung hängen nicht nur von der Geometrie des herzustellenden Bauteils sondern auch vom Verunreinigungsgehalt der verwendeten Rohstoffe ab.

Die Anwesenheit von Alkalien (bspw. Na) führt zu einer deutlichen Veränderung der Fließeigenschaften des Schlickers und zur Veränderung des Sinterverhaltens.

Die Fließfähigkeit des Schlickers kann durch eine leichte Modifikation der Korngrößenverteilung und des Wassergehaltes in den in Tabelle 1 angegeben Grenzen angepasst werden. Bei einem hohen Na-Gehalt muss die maximale Brenntemperatur gesenkt werden. Die Umwandlung des amorphen Quarzglases in unerwünschte kristalline Modifikationen wird durch die Verunreinigungen beschleunigt.

Typischerweise lässt sich die Reinheit des verwendeten Rohmaterials mit "mindestens 99,8% Si02" beschreiben.

Für die Fertigung wurden die in Tabelle 2 angegebene Restzusammensetzung als vorteilhaft erkannt:

Tabelle 2

| Angaben in Gew.-% | maximal Zulässiger Gehalt | typischer Gehalt Rohmaterial 1 | typischer Gehalt Rohmaterial 2 |
|---|---|---|---|
| Al2O3 | 0,08 | 0,06 | 0,035 |
| CaO | 0,016 | 0,007 | 0,005 |
| Fe2O3 | 0,0085 | 0,007 | 0,0023 |
| K2O | 0,009 | 0,007 | 0,0016 |
| MgO | 0,01 | 0,0077 | 0,0015 |
| Na2O | 0,005 | 0,004 | 0,0021 |

Die Prozessparameter beim Gießen der Grünlinge liegen innerhalb folgender Grenzen:

- Befüllen der Form unter (hydrostatischer) Druckbeaufschlagung des Schlickers über eine Dauer (je nach Tiegelmasse) zwischen 10 Minuten und 30 Minuten.
- Trocknungszeiten vom Beginn des Gießens bis zur Entformung: 0,5 Minuten bis mehrere Tage. Davon werden für eine erste Trockenphase, während der der Kern komplett in der Form verankert ist, so dass dessen formgebende Flächen mit dem Schlicker in Berührung stehen, zwischen 2 Stunden und 24 Stunden aufgewendet. Auf eine zweite Trocknungsphase, in der der Kern ein Stück aus der Form gezogen ist und das Schlickermaterial nicht mehr berührt; entfallen zwischen 36 Std. und 3 Tagen. Im Allgemeinen beeinflusst eine zu lange Trocknung die Qualität des Bauteils nicht.
- Verwendung von Überdruck: zwischen 0,02 bar bis 1,4 bar über Normaldruck. Eine weitere Anhebung des Drucks bringt keinen nennenswerten Vorteil und birgt die Gefahr, dass die Behälter oder Formen beschädigt werden.

- Temperatur. In der Regel Raumtemperatur: zwischen 15°C und 32 °C.

Die entstandenen Grünkörper können - in Abhg. der Wanddicke- nach folgenden Sinterprogrammen zu belastbaren Behältern gebrannt werden.

Schritt 1     Erwärmen von Raumtemperatur auf 90°C bis 120°C mit 10 bis 30 K/min.
Schritt 2     Halten der Temperatur (abhängig von der Wanddicke des Formkörpers) 12 Stunden bis 96 Stunden.
Schritt 3     Weiter Erwärmen mit 1 K/min bis 30 K/min auf 1030°C bis 1230 °C (ggf. weitere Haftezeiten in Abhängigkeit der Wanddicke des Formkörpers einbauen, z.B.: 24 Stunden bei 300 °C).
Schritt 4     Haltezeit (abhängig von der Wanddicke des Formkörpers) 0,25 Stunden bis 24 Stunden.
Schritt 5     Weiter Erwärmen auf die maximale Brenntemperatur zwischen 1050°C und 1150°C mit ca. 1 K/min.
Schritt 6     Halten bei der Maximaltemperatur von 1 Stunde bis 32 Stunden.
Schritt 7     Abkühlen auf 650°C; maximale Abkühlgeschwindigkeit: 350 K/min.
Schritt 8     Abkühlen auf Raumtemperatur (kann ungeregelt erfolgen).

## Patentansprüche

1. Verfahren zur Herstellung eines Quarzglasformkörpers mit den Schritten:

    - Einbringen eines Quarzglas-Wassergemisches in eine Gussform, welche eine Außenform und eine Innenform aufweist,
    - Trocknen des Quarzglas-Wassergemisches in der Gussform und
    - Entformen des so erzeugten Grünkörpers,

    **dadurch gekennzeichnet,**

    - **dass** zumindest Teile der formgebenden Flächen der Innenform aus einer wasserdichten Substanz gebildet werden und
    - **dass** während des Trocknens ein Überdruck auf das Quarzglas-Wassergemisch wirkt.

2. Verfahren nach Anspruch 1, **dadurch gekennzeichnet, dass** eine Druckdifferenz über die Gussform oder über Teile davon beim Entformen angelegt wird.

3. Verfahren nach Anspruch 1 oder 2, **dadurch gekennzeichnet, dass** eine Druckdifferenz über die Gussform oder über Teile davon beim Einbringen des Quarzglas-Wassergemisches angelegt wird.

4. Verfahren nach einem der vorstehenden Ansprüche, **dadurch gekennzeichnet,**
   **dass** die Gussform zur Herstellung eines Quarzglastiegels einen Kern als Innenform und eine Außenschale als Außenform aufweist, wobei das Quarzglas-Wassergemisch unter Ausnutzung der Schwerkraft von einem Niveau oberhalb des oberen Tiegelrandes durch eine Einlassöffnung in der Gussform im Tiegelbodenbereich eingebracht wird.

5. Verfahren nach einem der vorstehenden Ansprüche, **dadurch gekennzeichnet,**
   **dass** die Innenform zumindest teilweise mit einer aus der wasserdichten Substanz vorgefertigten Form verkleidet wird.

6. Verfahren nach einem der Ansprüche 1 bis 4, **dadurch gekennzeichnet,**
   **dass** die Innenform zumindest teilweise mit der wasserdichten Substanz beschichtet wird.

7. Verfahren nach einem der Ansprüche 1 bis 4, **dadurch gekennzeichnet,**
   **dass** die Innenform aus einem brennbaren Werkstoff, vorzugsweise aus PU-Schaum, besteht und nach dem Trocknen verbrannt wird.

8. Verfahren nach einem der vorstehenden Ansprüche, **dadurch gekennzeichnet,**
   **dass** die wasserdichte Substanz aus PU besteht.

9. Verfahren nach einem der Ansprüche 1 bis 7, **dadurch gekennzeichnet,**
   **dass** die wasserdichte Substanz aus Silikongummi besteht.

10. Verfahren nach einem der vorstehenden Ansprüche, **dadurch gekennzeichnet,**
    **dass** der Grünkörper nach dem Entformen gesintert wird.

11. Verfahren nach einem der vorstehenden Ansprüche, **dadurch gekennzeichnet,**
    **dass** die Außenform Hohlräume in Form eines Kanalsystems aufweist, welches mit dem Überdruck beaufschlagt wird.

12. Verfahren nach einem der vorstehenden Ansprüche, **dadurch gekennzeichnet,**
    **dass** der Überdruck ein hydrostatischer Druck ist, der auf das Quarzglas-Wassergemisch wirkt.

13. Verfahren nach Anspruch 12 in Verbindung mit Anspruch 4, **dadurch gekennzeichnet,**
    **dass** der hydrostatische Druck durch die Wahl der Füllhöhe über dem oberen Tiegelrand eingestellt wird.

14. Verfahren nach einem der Ansprüche 11 bis 13, **dadurch gekennzeichnet,**
    **dass** der Überdruck zwischen 0,02 bar und 1,4 bar über dem Normaldruck beträgt.

15. Verfahren nach einem der Ansprüche 11 bis 13, **dadurch gekennzeichnet,**
    **dass** der Überdruck zwischen 0,1 bar und 0,2 bar über dem Normaldruck beträgt.

16. Verfahren nach einem der vorstehenden Ansprüche, **dadurch gekennzeichnet,**
    **dass** die Gussform unter Überdruck über eine Zeitspanne von 5 Minuten und einer Stunde vollständig befüllt wird.

17. Verfahren nach einem der vorstehenden Ansprüche, **dadurch gekennzeichnet,**
    **dass**, während einer ersten Phase des Trocknens der Überdruck auf das Quarzgfas-Wassergemisch wirkt und während einer zweiten Phase des Trocknens die Innenform von dem angetrockneten Grünkörper abgehoben wird.

18. Verfahren nach Anspruch 17, **dadurch gekennzeichnet, dass** die erste Phase des Trocknens zwischen 2 und 24 Stunden andauert.

19. Verfahren nach Anspruch 17 oder 18, **dadurch gekennzeichnet,**
    **dass** die zweite Phase des Trocknens zwischen 10 Stunden und 12 Tagen andauert.

20. Verfahren nach einem der vorstehenden Ansprüche, **dadurch gekennzeichnet,**
    **dass** das Quarzglas-Wassergemisch beim Einbringen in die Gussform einen Wassergehalt von höchsten 15% aufweist.

21. Schlickergegossener und gesinterter Formkörper aus Quarzglas, **dadurch gekennzeichnet,**
    **dass** der Formkörper nach dem Verfahren gemäß einem der Ansprüche 1 bis 20 hergestellt wurde, wobei der Formkörper einen Gehalt an Poren von weniger als 15 Vol.-% enthält.

22. Formkörper nach Anspruch 21, **dadurch gekennzeichnet, dass** der Formkörper im Oberflächenbereich einen Gehalt an Verunreinigungen von weniger als 0,2 Gew.-% aufweist.

23. Formkörper nach einem der Ansprüche 21 oder 22, **dadurch gekennzeichnet,**
    **dass** der Formkörper ein Tiegel ist.

24. Tiegel nach Anspruch 23, **dadurch gekennzeichnet, dass** der Tiegel einen von der Innenseite zur Außenseite abnehmenden Gehalt von Silizium und/oder Siliziumnitrid aufweist.

25. Tiegel nach Anspruch 24, **dadurch gekennzeichnet, dass** Gehalt von Silizium und/oder Siliziumnitrid auf der Innenseite höchstens 8 Gew.-% beträgt.

26. Tiegel nach einem der Ansprüche 23 bis 25, **dadurch gekennzeichnet,**
    **dass** der Tiegel bei Abmessungen von wenigstens 550 mm Länge, 550 mm und 350 mm Höhe Wanddicken von weniger als 20 mm und eine Bodendicke von weniger als 24 mm aufweist.

27. Verwendung eines Formkörpers nach einem der Ansprüche 21 bis 26 zur Herstellung von Siliziumblöcken.

28. Gussform zur Herstellung von Quarzglastiegeln mit einer Außenschale und einem Kern, **dadurch gekennzeichnet, dass** zumindest Teile der formgebenden Flächen des Kerns aus einer wasserdichten Substanz gebildet werden und die Gussform einen Einfüllstutzen oberhalb eines oberen Tiegelrandes und eine Einlassöffnung im Tiegelbodenbereich aufweist.

29. Gussform nach Anspruch 28, **dadurch gekennzeichnet, dass** die wasserdichte Substanz aus einem Silikongummi oder aus PU besteht.

30. Gussform nach einem der Ansprüche 28 oder 29, **dadurch gekennzeichnet, dass** die Verkleidung der Gussform aus der wasserdichten Substanz perforiert ist.

31. Gussform nach einem der Ansprüche 28 bis 30, **dadurch gekennzeichnet, dass** die Verkleidung strukturiert ist.

32. Gussform nach einem der Ansprüche 28 bis 31, **dadurch gekennzeichnet, dass** die Gussform zumindest teilweise aus Gips besteht.

33. Gussform nach einem der Ansprüche 28 bis 32, **gekennzeichnet durch** Hohlräume im Bereich der Außenschale in Form eines Kanalsystems und wenigstens ein Anschlussmittel zum Anschließen eines Druckmittels.

34. Gussform nach Anspruch 33, **dadurch gekennzeichnet, dass** das Kanalsystem durch wenigstens einen in die Gussform eingelassenen Gewebeschlauch gebildet wird.

35. Gussform nach einem der Ansprüche 28 bis 34, **dadurch gekennzeichnet, dass** die Einlassöffnung im Bereich des Übergangs vom Tiegelboden zu den Tiegelwänden angeordnet ist.

Fig. 1

Fig. 2

Fig. 3

Fig. 4A

Fig. 4B

Fig. 4C

Fig. 5

Fig. 6A

Fig. 6B

Fig. 6C

**Europäisches Patentamt**

**EUROPÄISCHER RECHERCHENBERICHT**

Nummer der Anmeldung

EP 07 12 2836

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2005/016837 A (SAINT GOBAIN CT DE RECH S ET D [FR]; LINNOT CYRIL [FR]; POULLAIN BERNA) 24. Februar 2005 (2005-02-24) * Seite 7, Zeilen 25-27; Ansprüche 1,4,10,11,13,17,23,27,28,33; Abbildung 1 * * Seite 9, Zeilen 19,20 * * Seite 13, Zeile 24 - Seite 14, Zeile 31 * * Seite 16, Zeilen 1-4 * * Seite 17, Zeilen 10-31; Beispiel 1 * ----- | 1-35 | INV. C03B19/06 B28B1/26 |
| X | US 3 431 332 A (CUMMINGS HOWARD B) 4. März 1969 (1969-03-04) * Spalte 1, Zeilen 36-39 * * Spalte 3, Zeile 52 - Spalte 4, Zeile 16; Abbildung 1 * * Spalte 5, Zeilen 13-18 * ----- | 28,32 | |
| D,X | WO 2006/089754 A (HERAEUS QUARZGLAS [DE]; SHINETSU QUARTZ PROD [JP]; SAKAGUCHI TSUKASA []) 31. August 2006 (2006-08-31) * Seite 9, Zeilen 3-20 * ----- | 28-35 | |
| A | US 3 481 010 A (COLBURN STEVEN C ET AL) 2. Dezember 1969 (1969-12-02) * Spalte 2, Zeilen 50-55 * * Spalte 4, Zeilen 5-33 * ----- | 17 | RECHERCHIERTE SACHGEBIETE (IPC) B28B C03B |
| A | DE 26 41 975 A1 (GERSTETTER REINHOLD) 23. März 1978 (1978-03-23) * Seite 5, Zeilen 1-11; Abbildung 2 * * Seite 6, Zeilen 5-22 * * Seite 7, Zeile 15 - Seite 8, Zeile 3 * ----- | 11,33,34 | |
| A | JP 02 009604 A (ITO KATSUNOBU) 12. Januar 1990 (1990-01-12) * Zusammenfassung * ----- | 11,33,34 | |

Der vorliegende Recherchenbericht wurde für alle Patentansprüche erstellt

| Recherchenort | Abschlußdatum der Recherche | Prüfer |
|---|---|---|
| Den Haag | 11. März 2008 | Creux, Sophie |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 07 12 2836

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

11-03-2008

| Im Recherchenbericht angeführtes Patentdokument | Datum der Veröffentlichung | Mitglied(er) der Patentfamilie | Datum der Veröffentlichung |
|---|---|---|---|
| WO 2005016837 A | 24-02-2005 | CN 1845881 A<br>EP 1663881 A1<br>FR 2858611 A1<br>JP 2007501761 T<br>US 2007082149 A1 | 11-10-2006<br>07-06-2006<br>11-02-2005<br>01-02-2007<br>12-04-2007 |
| US 3431332 A | 04-03-1969 | KEINE | |
| WO 2006089754 A | 31-08-2006 | KEINE | |
| US 3481010 A | 02-12-1969 | KEINE | |
| DE 2641975 A1 | 23-03-1978 | KEINE | |
| JP 2009604 A | 12-01-1990 | KEINE | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10251076
- DE 10244040
- WO 2006089754 A
- EP 1516864 A2